**Europäisches Patentamt**

**European Patent Office**

**Office européen des brevets**

(19)

(11) Veröffentlichungsnummer: **0 002 670**
B1

(12) **EUROPÄISCHE PATENTSCHRIFT**

(45) Veröffentlichungstag der Patentschrift: **01.04.81**

(21) Anmeldenummer: **78101485.7**

(22) Anmeldetag: **01.12.78**

(51) Int. Cl.³: **H 01 L 21/225,**
**H 01 L 21/70**

(54) Verfahren zum Herstellen eines bipolaren Transistors in einem Halbleitersubstrat.

(30) Priorität: **22.12.77 US 863182**

(43) Veröffentlichungstag der Anmeldung:
**11.07.79 Patentblatt 79/14**

(45) Bekanntmachung des Hinweises auf die Patenterteilung:
**01.04.81 Patentblatt 81/13**

(84) Benannte Vertragsstaaten:
**DE FR GB NL SE**

(56) Entgegenhaltungen:
**DE - A - 2 363 466**
**DE - A - 2 633 714**
**FR - A - 2 387 516**
**US - A - 3 904 450**

**IBM TECHNICAL DISCLOSURE BULLETIN,**
**vol. 19, no. 12, May 1977, Armonk, N.Y., USA**
**C.G. JAMBOTKAR "Method for reducing the**
**emitter-base contact distance in bipolar**
**transistors"**
**Seiten 4601 bis 4604**

(73) Patentinhaber: **International Business Machines**
**Corporation**
**Armonk, N.Y. 10504 (US)**

(72) Erfinder: **Bhattacharyya, Arup**
**18 Glenwood Drive**
**Essex Junction, VT 05452 (US)**
Erfinder: **Wiedman III, Francis Walter**
**Road 2**
**Stowe, VT 05672 (US)**

(74) Vertreter: **Böhmer, Hans Erich, Dipl.-Ing.**
**Schönaicher Strasse 220**
**D-7030 Böblingen (DE)**

Courier Press, Leamington Spa, England.

## Verfahren zum Herstellen eines bipolaren Transistors in einem Halbleitersubstrat

Die Erfindung betrifft ein Verfahren zur Herstellung eines bipolaren Transistors mit einem Halbleitersubstrat eines ersten Leitungstyps mit einer einen Transistorbereich begrenzenden, eingelassenen Oxid-Isolationszone, bei dem zunächst eine Kollektorzone und eine Basiszone im Halbleitersubstrat hergestellt werden, bei dem anschließend auf einem ersten Bereich der Oberfläche des Halbleitersubstrats eine erste leitende Schicht aus einem in einen isolierenden Zustand überführbaren Material aufgebracht wird, bei dem Störelemente des ersten Leitungstyps aus der ersten leitenden Schicht durch den ersten Bereich der Oberfläche des Halbleitersubstrats hindurch in die Basiszone eingeführt werden, bei dem auf der ersten leitenden Schicht eine erste Isolierschicht hergestellt und auf der ersten Isolierschicht und auf einem zweiten Bereich der Oberfläche des Halbleitersubstrats eine zweite leitende Schicht aufgebracht wird.

Ein derartiges Verfahren ist z.B. aus der US-A-3 904 450 bekannt. Integrierte Halbleiter-Speicherschaltungen, insbesondere solche, die Speicherzellen mit einem Kondensator und einem Schalter enthalten, haben zu sehr hohen Dichten der Speicherzellen geführt. Eine der einfachsten Schaltungen, mit der sich sehr kleine Speicherzellen erzielen lassen, ist in der DE - C - 1 774 482 beschrieben. Jede dieser Zellen verwendet einen Speicherkondensator und einen als Schalter wirkenden Feldeffekttransistor, der selektiv den Kondensator an eine Bit-Abfühlleitung anzuschalten vermag. In der DE - B - 2 363 466 ist eine aus einem Feldeffekttransistor bestehende Speicherzelle der in der oben genannten Patentanmeldung beschriebenen Art offenbart, die dadurch zu kleinen Abmessungen gelangt, daß eine Schicht aus dotiertem polykristallinem Silicium durch eine auf der Oberfläche eines Halbleitersubstrats liegende dielektrische Schicht von dieser getrennt, mit dem Substrat einen Speicherkondensator bildet.

In der DE - A - 2 621 136 der Anmelderin ist eine Speicheranordnung aus kleinen Speicherzellen mit Speicherkondensatoren und bipolaren Transistoren offenbart. In dieser wortorganisierten Anordnung ist bei jedem Kondensator eine Klemme an einer gesonderten Bit-Abfühlleitung angeschlossen, während ausgewählte, ein Wort bildende Zellen gemeinsam gleichzeitig dadurch angesteuert werden, daß ein Wortimpuls für eine Ankopplung an die andere Klemme des Speicherkondensators dieses Wortes benutzt wird. Durch gleichzeitige Ansteuerung der anderen Klemme aller Speicherkondensatoren eines bestimmten Wortes wird eine Isolation zwischen den Zellen des Wortes nicht benötigt. Diese bipolare Transistor-Speicheranordnung hat sehr gute Betriebseigenschaften, da die darin verwendeten bipolaren Transistoren viel schneller arbeiten als Feldeffekttransistoren. Viele bekannte bipolare Transistoren der beispielsweise in der US - A - 3 904 450 offenbarten Bauart, die durch Diffusion von Störelementen aus einer polykristallinen Siliciumschicht in ein Halbleitersubstrat hergestellt werden, können als bipolare Speicheranordnung mit zufriedenstellendem Betriebsverhalten benutzt werden, doch sind für eine wesentliche Verbesserung des Betriebsverhaltens von Speicheranordnungen Transistoren mit sehr guten Leistungen erforderlich.

Aus der Zeitschrift IBM-Technical Disclosure Bulletin, Vol. 19, Nr. 12, Mai 1977, Seiten 4601 bis 4604 ist ein Verfahren zum Herstellen eines Transistors in einem Halbleitersubstrat eines ersten Leitungstyps mit einer einen Transistorbereich begrenzenden, eingelassenen Oxid-Isolationszone, bei dem zunächst die Kollektor- und Basiszone im Halbleitersubstrat hergestellt werden, bei dem anschließend auf einen ersten Bereich der Oberfläche des Halbleitersubstrats eine erste leitende Schicht aus einem in einem isolierenden Zustand überführbaren Materials aufgebracht wird, bekannt, bei dem auf der ersten leitenden Schicht eine erste Isolierschicht derart hergestellt wird, daß das an der außen liegenden Oberfläche angrenzende Material der ersten leitenden Schicht in einen isolierenden Zustand überführt wird, und bei dem auf der ersten Isolierschicht und auf einem zweiten Bereich der Oberfläche des Halbleitersubstrats eine zweite leitende Schicht aufgebracht wird.

Aufgabe der Erfindung ist es also, ein Verfahren der oben näher bezeichneten Art zum Herstellen bipolarer Transistoren mit sehr kleinen Abmessungen und außerordentlich guten Leistungen anzugeben, welche entweder in üblicher Weise abwärts arbeiten oder aber aufwärts, d.h., daß dann der Kollektor als elektrischer Emitter wirkt. Vorzugsweise soll dies dadurch erreicht werden, daß in dieser verbesserten Transistorstruktur Basis und Emitter einen äußerst geringen Abstand mit selbstausrichtenden Kontakten haben. Dabei soll sich dann bei einer Verwendung in einer Speicherzelle eine höhere Speicherdichte und damit eine Verringerung der Zugriffszeit ergeben. Damit soll erreicht werden, daß bei einer solchen verbesserten Speicheranordnung die Abstände der Wortleitungen verringert und die Übertragungsverzögerung im wesentlichen beseitigt wird. Vorzugsweise soll die verbesserte bipolare Transistor-Speicheranordnung so aufgebaut sein, daß keine epitaxiale Schicht erforderlich ist, wobei die Herstellung durch Ionen-Implantationsverfahren möglich ist.

Dies wird erfindungsgemäß dadurch erreicht, daß die einen zweiten Leitungstyp aufweisende Kollektorzone zur Bildung der Basiszone des ersten Leitungstyps teilweise mit Abstand von der Oberfläche des Halbleitersubstrats hergestellt wird, daß das Einführen der Störelemente aus der ersten leitenden Schicht zur Bildung eines Kontaktbereiches der Basiszone gilt, daß die erste Isolierschicht durch Überführung des an der außen liegenden Oberfläche angrenzenden Materials der ersten leitenden Schicht in einen isolierenden Zustand hergestellt wird, so daß die zweite leitende Schicht um die Dicke der ersten Isolierschicht mit Abstand von der verbleibenden ersten leitenden Schicht auf die Oberfläche des Halbleitersubstrats aufgebracht wird und daß Störelemente des zweiten Leitungstyps aus der zweiten leitenden Schicht durch den zweiten Bereich der Oberfläche des Halbleitersubstrats hindurch in die Basiszone zur Bildung einer Emitterzone eingeführt werden, die somit einen innerhalb der Dicke der ersten Isolierschicht liegenden Abstand von dem ersten Bereich aufweist.

Eine besondere Ausführungsart der Erfindung besteht darin, daß die Kollektorzone durch Ionen-Implantation in dem Transistorbereich mit zunehmender, von der Oberfläche des Substrats ausgehender oberer Grenze gebildet wird, daß ferner die Ionen über die gesamte Oberfläche des Transistorbereichs durch die auf der Oberfläche des Halbleitersubstrats niedergeschlagenen Schichten, die dem Durchdringen der Ionen einen unterschiedlichen Widerstand entgegensetzen, eingeführt werden, und daß die Ionen durch Schichten aus verschiedenen Materialien hindurch implantiert werden, wobei eines der Materialien vorzugsweise ein Photolack ist. Dabei wird es als besonders günstig angesehen, wenn als erste leitende Schicht polykristallines Silicium, Aluminium, Tantal, Zirkon, Niob oder ein Metallsilicid verwendet wird.

Eine weitere besondere Ausführungsart der Erfindung zeichnet sich dadurch aus, daß die erste leitende Schicht auf den ersten Bereich dadurch aufgebracht wird, daß innerhalb der Oxidations-Isolationszone auf der Oberfläche des Halbleitersubstrats eine isolierende Schicht aufgebracht wird, daß anschließend darauf eine Photolackschicht aufgebracht wird, daß dann zur Festlegung des ersten Bereichs eine Öffnung durch die Photolackschicht und die isolierende Schicht hindurch geätzt wird und daß dann die erste leitende Schicht durch diese Öffnung auf die Substratoberfläche aufgebracht wird.

Von besonderem Vorteil ist das erfindungsgemäße Verfahren beim gleichzeitigen Herstellen mehrerer Transistoren in einem einzigen Transistorbereich. Man geht dabei so vor, daß die erste leitende Schicht auf eine Anzahl ausgewählter, innerhalb des Transistorbereichs liegender erster Bereiche der Substratoberfläche aufgebracht wird, daß auf der ersten Isolierschicht und auf einer mit der Anzahl der ersten Bereiche gleich großen Anzahl von zweiten Bereichen der Substratoberfläche eine gleich große Anzahl von voneinander einen Abstand aufweisenden Einzelbereichen der zweiten leitenden Schicht in der Weise angebracht werden, daß je einer der zweiten Bereiche je einem der ersten Bereiche unmittelbar benachbart ist.

Eine besondere Ausführungsart dieser Ausführungsform der Erfindung besteht darin, daß über jedem der Einzelbereiche der zweiten leitenden Schicht eine dritte Isolierschicht aus dielektrischem Material aufgebracht wird und daß darüber eine gleich große Anzahl dritter leitender Schichten zur Bildung einer gleich großen Anzahl von Kondensatoren aufgebracht wird. Weitere besondere Ausführungsarten der Erfindung sind in den Ansprüchen 7 bis 9, 11 bis 14 und 16 angegeben.

Die Erfindung wird nunmehr anhand von Ausführungswegen in Verbindung mit den beigefügten Zeichnungen im einzelnen näher beschrieben.

In den Zeichnungen zeigen

Fign. 1—5 Schnittansichten eines Ausführungsweges einer bipolaren Transistorstruktur unter Angabe der verschiedenen Verfahrensschritte bei der Herstellung gemäß der Erfindung,

Fig. 6 eine Draufsicht auf die in Fign. 1—5 dargestellte Transistorstruktur,

Fig. 7 eine Draufsicht auf eine Speicheranordnung mit gemäß der Erfindung hergestellten Transistoren mit zwei Speicherworten, die jeweils in einem vertrieft liegenden, gesonderten isolierten Bereich liegen,

Fig. 8 eine Schnittansicht der Speicheranordnung längs der Linie 8—8 in Fig. 7,

Fig. 9 eine Schnittansicht längs der Linie 9—9 der in Fig. 7 gezeigten Speicheranordnung,

Fig. 10 eine Schnittansicht längs der Linie 10—10 der in Fig. 7 gezeigten Speicheranordnung,

Fig. 11 eine Schaltung, wie sie zum Betreiben zweier benachbarter Worte einer Speicheranordnung mit gemäß der Erfindung hergestellten Transistoren benutzt werden kann und

Fig. 12 ein Impulsdiagramm zur Darstellung, wie die Schaltung nach Fig. 11 betrieben werden kann.

Beschreibung der Ausführungswege

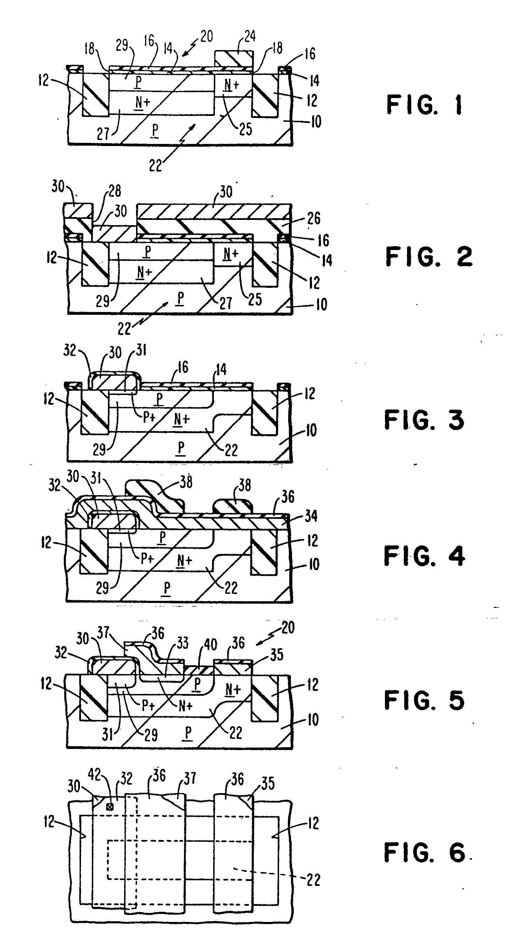

In den Fign. 1—5 sind Schnittansichten einer gemäß der Erfindung hergestellten Ausführungsform einer Transistorstruktur dargestellt. Dabei zeigt Fig. 1 ein vorzugsweise aus niedrig dotiertem P-leitenden Silicium bestehendes Halbleitersubstrat 10 mit einer eingelassenen Oxid-Isolationszone 12, die einen Bereich des Substrats definiert, wie dies noch deutlicher aus Fig. 6 zu erkennen ist. Auf der Oberfläche des Substrats 10 ist eine isolierende Siliciumdioxid-Schicht 14 aufgewachsen, über der eine isolierende Silicium-Nitrid-Schicht 16 niedergeschlagen ist. In der Siliciumdioxid-Schicht 14 und der Silicium-Nitrid-Schicht 16 ist eine Öffnung 18 angebracht, die damit eine eingelassene Oxid-Isolationszone 12 definiert. Nach Herstellung der Öffnung 18 in der Siliciumoxid- und Silicium-Nitrid-Schicht 14 und 16 durch bekannte Verfahren, wird das Halbleitersubstrat 10 innerhalb der Öffnung 18 beispielsweise durch bekanntes reaktives Ionen-Ätzen geätzt und dann zur Bildung der eingelassenen Oxid-Isolationszone 12 oxydiert. Zur Bildung eines Transistors 20 innerhalb der Oxid-Isolationszone 12 wird eine Kollektorzone 22 unter der Oberfläche des Halbleitersubstrats 10 durch Ionen-Implantation gebildet. Die vergrabene Kollektorzone 22 wird dadurch hergestellt, daß man zunächst über der Silicium-Nitrid-Schicht 16 eine Photolackschicht 24 aufbringt und dann durch an sich bekannte Maskenverfahren die gesamte Photolackschicht 24 mit Ausnahme der in Fig. 1 angedeuteten Bereiche entfernt. Die Dicke der Photolackschicht 24 ist derart gewählt, daß Ionen, zum Beispiel Phosphor-Ionen, die durch die Photolackschicht 24 in das Halbleitersubstrat 10 hinein implantiert werden, in dem Halbleitersubstrat 10 von der Oberfläche nach einer Tiefe unterhalb der flachen Eindringung der Ionen verteilt werden, die nur durch die Siliciumoxid-Schicht 14 und die Silicium-Nitrid-Schicht 16 innerhalb der Oxid-Isolationszone 12 eindringen, wie dies bei 25 angezeigt ist. Der Hauptteil der vergrabenen Kollektorzone 22 ist durch einen Unterbereich 27 angedeutet. Im Halbleitersubstrat 10 wird zur Bildung einer Basiszone 29 des Transistors die zwischen dem Unterbereich 27 und der Siliciumdioxid-Schicht 14 liegenden P-leitende Zone erzeugt. Nach Herstellung der Kollektorzone 22 im Halbleitersubstrat 10 wird der verbleibende Teil der Photolackschicht 24 von der Oberfläche der Silicium-Nitrid-Schicht 16 abgezogen und es wird eine zweite Photolackschicht 26 über alles auf der gesamten Oberfläche der Struktur aufgebracht. Unter Verwendung bekannter Maskenverfahren wird ein Teil der Photolackschicht 26 zur Bildung einer Öffnung 28 auf der Oberfläche des Halbleitersubstrats 10 entfernt. Anschließend wird eine Schicht aus in den isolierenden Zustand überführbarem Material, wie zum Beispiel eine erste leitende Schicht 30 aus mit Bor dotiertem polykristallinen Silicium über der Photolackschicht 26 aufgetragen und auch durch die Öffnung 28 auf der Oberfläche des Halbleitersubstrats 10 bis zu einer Dicke von etwa 0,6 μm niedergeschlagen. Dann wird die Photolackschicht 26 entfernt, wodurch auch die gesamte, aus polykristallinem Silicium oder Polysilicium bestehende erste leitende Schicht 30 mit Ausnahme desjenigen Teils entfernt wird, der nicht über der Photolackschicht 26 liegt. Durch Anwendung von Naß-Trocken-Naß-Oxidationsverfahren wird die Oberfläche der ersten Polysilicium-Schicht 30 zur Bildung einer ersten Isolierschicht 32 aus Polysilicium-Oxid oxydiert, wie dies Fig. 3 zeigt. Während des Oxydationsschritts wird das in der ersten leitenden Schicht 30 aus Polysilicium enthaltene Bor in die Basiszone 29 eingetrieben und stellt damit einen Kontaktbereich 31 her. Nach Entfernen der Siliciumoxid- und Nitrid-Schichten 14 und 16 in Fig. 3 wird eine zweite leitende Schicht 34 aus in den isolierenden Zustand überführbarem Material, vorzugsweise aus Polysilicium, über der Oberfläche der Struktur niedergeschlagen, wie dies in Fig. 4 angezeigt ist. Die zweite leitende Schicht 34 aus Polysilicium kann beispielsweise mit Arsen, d.h. einem N-leitenden Störelement dotiert sein und kann ebenso eine Dicke von angenähert 0,6 μm aufweisen. Über dieser zweiten leitenden Schicht 34 wird eine dritte Isolierschicht 36 aus Silicium-Nitrid niedergeschlagen, die dann mit einer Photolackschicht 38 überzogen wird. Durch ein Photomaskenverfahren wird die gesamte Photolackschicht 38 mit Ausnahme eines Bereichs der Photolackschicht 38 entfernt, der über dem Unterbereich 25 der vergrabenen Kollektorzone 22 liegt, sowie mit Ausnahme eines davon auf Abstand liegenden Teils der Photolackschicht 38, der über einem Bereich der ersten leitenden Schicht 30 und einem benachbarten, anschließenden Teil des Unterbereichs 27 der Kollektorzone 22 liegt, wie dies Fig. 4 zeigt. Die freiliegenden Abschnitte der Silicium-Nitrid-Schicht 36 werden dann durch trockene oder naße Ätzverfahren entfernt und die Bereiche der zweiten leitenden Schicht 34 unter der freiliegenden Silicium-Nitrid-Schicht 36 werden ebenfalls durch Ätzmittel, wie zum Beispiel eine chemische Lösung aus Salpetersäure/Essigsäure oder durch trockene Plasmaätzung entfernt. Nach Abätzen der zweiten leitenden Schicht 34 verbleibt nur der Bereich 37 der zweiten leitenden Schicht über der ersten leitenden Schicht 30 und in Kontaktverbindung mit der Oberfläche des Halbleitersubstrats 10 ebenso wie der die Kollektorzone 22 kontaktierende Teil 35, wie dies Fig. 5 zeigt. Die Photolackschicht 38 wird danach abgezogen und die freiliegende Oberfläche des Halbleitersubstrats 10 zwischen dem Teil 35 und dem Bereich 37 der zweiten leitenden Schicht 34 wird zur Bildung einer isolierenden Schicht 40 oxydiert. Außerdem wird das Arsen leicht in die Basiszone 29 eingetrieben und bildet eine flache Emitter-Zone 33 in engem Abstand vom Basis-Kontaktbereich 31. Dieser Abstand liegt innerhalb der Dicke der ersten Isolierschicht 32. Zur Fertigstellung der Transistorstruktur 20 wird eine Kontaktbohrung in der ersten Isolierschicht 32 für einen Kontakt 42 nach der ersten leitenden Schicht 30 hergestellt, wie dies in der Draufsicht von Fig. 6 gezeigt ist. Anschließend kann an den Bereichen 35, 37 und am Kontakt 42 für entsprechende Anschlüsse nach Entfernen aller oder eines Teils der Silicium-Nitrid-Schicht 36 in Fig. 5 eine Metallisierung angebracht werden.

Es sei darauf verwiesen, daß durch Anwendung des erfindungsgemäßen Verfahrens die durch den Bereich 37 der zweiten leitenden Schicht 34 definierte Emitterzone 33 innerhalb der Dicke der ersten Isolierschicht 32 einen sehr geringen Abstand von dem durch die erste leitende Schicht 30 definierten Basis-Kontaktbereich 31 aufweist. Diese Anordnung ergibt einen niedrigen Basiswiderstand und damit einen sehr schnellen bipolaren Transistor. Ferner wird durch die Anordnung der Kollektorzone unmittelbar im Anschluß an die eingelassene Oxid-Isolationszone 12 ein weiterer Vorteil dadurch erreicht, daß zwischen Kollektorzone und Basiszone eine hohe Durchschlagsspannung erreicht und außerdem eine geringe Kapazität des Schichtübergangs erzielt wird.

Es sein ferner darauf hingewiesen, daß die Unterbereiche 25 und 27 der Kollektorzone 22 während der Wärmeschritte des Verfahrens bis zur endgültigen Formgebung der in Fig. 5 gezeigten Kollektorzone 22 allmählich ihre Form verändern. Man erreicht damit eine durchgehende Kollektorzone und damit einen geringen Kollektorwiderstand.

Beispielsweise kann die in Fign. 4 und 5 gezeigte Silicium-Nitrid-Schicht 36 durch eine zweite Isolierschicht über den Bereichen 35 und 37 ersetzt werden, da Kontaktbohrungen durch jede auf den Bereichen 35 und 37 gebildete Oxid-Schicht hergestellt werden können. Außerdem ist es nicht erforderlich, daß sich die Kollektorzone 22 bis an die Oberfläche des Halbleitersubstrats 10 erstreckt, dan in bestimmten Fällen auch andere Möglichkeiten einer Kontaktierung der Kollektorzone bestehen. Außerdem können eine oder beide leitende Schichten durch Schichten aus Metallsiliciden, beispielsweise Molybdän-Silicid, Wolfram-Silicid oder andere und in bestimmten Fällen aus selbstoxydierenden Metallen, wie z.B. Aluminium, Tantal, Niob und Zirkon ersetzt werden.

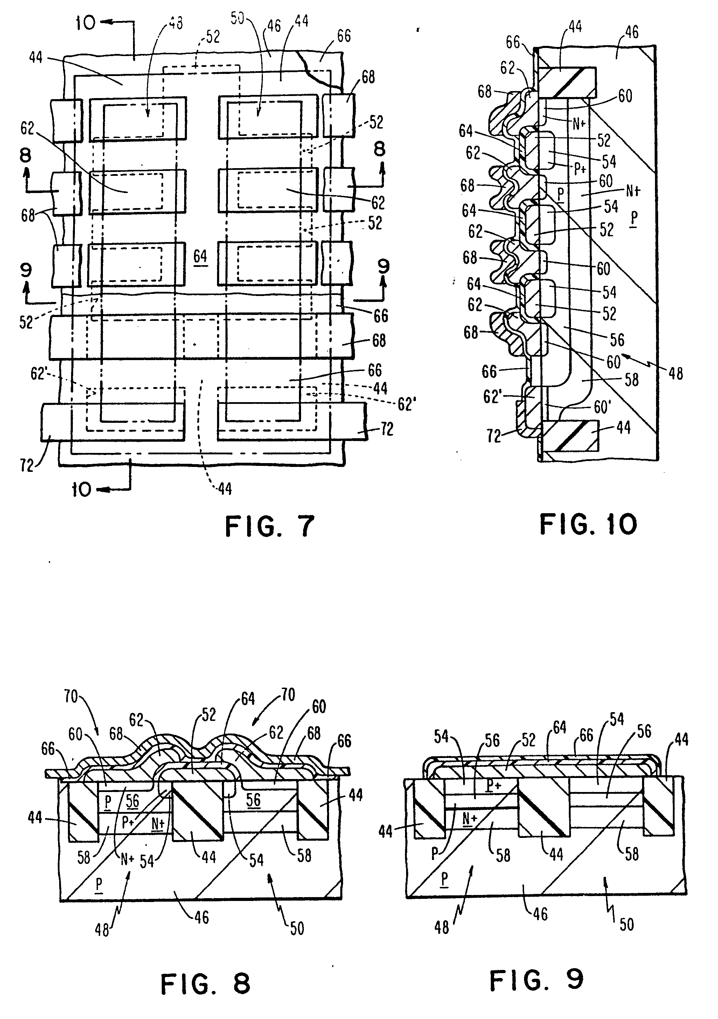

Fig. 7 zeigt eine Draufsicht auf einen Speicher, der die bipolare Transistorstruktur gemäß Fign. 1—6 verwendet und damit eine hohe Dichte der Speicherzellen aufweist, die bei hohen Geschwindigkeiten arbeiten. Fign. 8, 9 und 10 sind Schnittansichten des in Fig. 7 gezeigten Speichers längs der Schnittlinien 8—8, 9—9 bzw. 10—10. Wie in den Fign. 7—10 gezeigt, wird in einem Halbleitersubstrat 46, das vorzugsweise aus gering dotiertem, P-leitenden Silicium besteht, eine eingelassene Oxid-Isolationszone 44 zur Bildung zweier benachbarter, isolierter Transistorbereiche 48 und 50 im oberen Teil des Halbleitersubstrats 46 hergestellt.

Durch Einsatz der in Verbindung mit der Herstellung der in Fign. 1—6 gezeigten bipolaren Transistorstruktur beschriebenen Verfahren wird zunächst eine mit Bor dotierte erste leitende Schicht 52 aus Polysilicium gebildet, die bei 54 einen Kontakt mit der Basiszone 56 eines jeden der innerhalb der Transistorbereiche 48 und 50 gebildeten Transistoren hergestellt wird, nachdem in jedem der isolierten Transistorbereiche 48 und 50 gemäß dem im Zusammenhang mit der Transistorstruktur in Fig. 1—6 beschriebenen Verfahren eine vergrabene Kollektorzone 58 gebildet ist. Die Emitterzonen 60 werden dadurch erzeugt, daß man Arsen als Dotierungsstoff aus der zweiten leitenden Schicht 62 in die Transistorbereiche 48 und 50 eintreibt, wie dies auch aus Fig. 8 und 10 zu ersehen ist. Eine erste Isolierschicht 64 trennt die erste leitende Schicht 52 von der zweiten leitenden Schicht 62. Es sei darauf hingewiesen, daß die vergrabene Kollektorzone 58 eine gemeinsame Kollektorzone und die Basiszonen 56 einer jeden der Emitterzonen 60 der Transistorbereiche 48 und 50 zugeordnet ist, wie dies deutlich aus Fig. 10 zu erkennen ist. Über der zweiten leitenden Schicht 62 liegt eine dielektrische Schicht, die vorzugsweise eine Isolierschicht 66 aus Silicium-Nitrid ist, die in Fig. 7 zum Teil weggebrochen ist. Anschließend wird eine metallische Schicht, beispielsweise aus mit Kupfer dotiertem Aluminium über der aus Silicium-Nitrid bestehenden Isolierschicht 66 niedergeschlagen und zur Herstellung von Bit-Abfühlleitungen 68 geätzt, wobei die oberen drei Leitungen 68 in Fig. 7 teilweise weggebrochen sind. Man sieht insbesondere aus Fig. 8, daß die zweite leitende Schicht 62 aus Polysilicium, die Isolierschicht 66 und die Bit-Abfühlleitung 68 an jeder der Emitterzonen 60 einen Speicherkondensator 70 bilden. Man sieht insbesondere in Fig. 9, daß die erste leitenden Schicht 52 einen wesentlichen Teil der Basiszone 56 berührt und damit eine Fehlausrichtung klein hält, wenn die Wortleitung des Speichers an die erste leitende Schicht 52 angeschlossen wird.

Zur Herstellung von Anschlüssen an jede der vergrabenen Kollektorzonen 58 wird das Arsen im Bereich 62' der zweiten leiltenden Schicht 62 in die $N^+$-leitende Kollektorzone 58 zur Bildung eines Kontaktbereiches 60' eingetrieben, während gleichzeitig die Emitterzonen 60 in der Basiszone 56 gebildet werden. Ein ohmscher oder metallischer Kontaktbereich wird nach jedem der Bereiche 62' dadurch hergestellt, daß vor dem Niederschlag des mit Kupfer dotierten Aluminiums, die über dem Bereich 62' liegende Isolierschicht abgeätzt wird, worauf durch Maskierung Metallkontakte 72 zur gleichen Zeit hergestellt werden, zu der auch die Bit-Abfühlleitungen 68 gebildet werden.

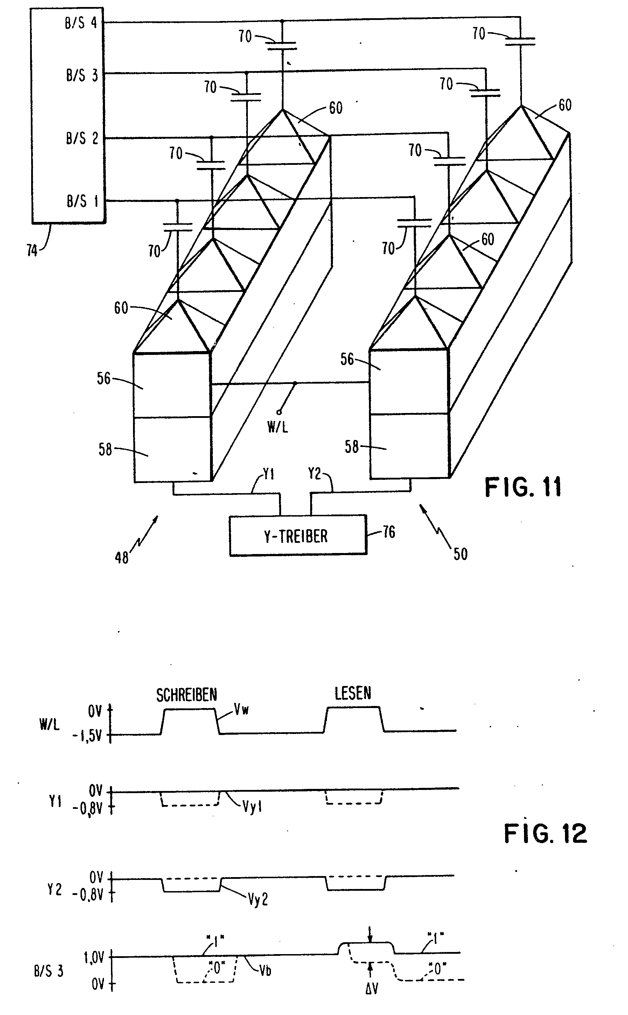

Zum besseren Verständnis der Arbeitsweise des in Fig. 7—10 dargestellten Speichers ist eine vereinfachte Darstellung des Speichers in Fig. 11 gezeigt, bei dem gleichartige Elemente des Speichers mit den gleichen Bezugszeichen wie in den Fign. 7—10 versehen sind. In Fig. 11 sind außerdem die Treiberstufen, die Abfühlstufen und die Auswahlschaltungen zum Betrieb des Speichers angedeutet. Der Speicher enthält die Transistorbereiche 48 und 50 mit jeweils vier Speicherkondensatoren 70 zum Einspeichern von vier Bit Information in vier Speicherzellen. Selbstverständlich könnte jeder der Transistorbereiche 48 und 50 viel mehr als nur vier Bit enthalten, wobei die hier gezeigten vier Bit nur der Erläuterung dienen. In Fig. 12 ist ein Impulsdiagramm dargestellt, das zur Erläuterung des Speichers dienen soll.

Zum Einschreiben einer Eins in einen der vier Speicherkondensatoren 70 des Transistorbereichs 50, beispielsweise in den an der Bit-Abfühlleitung B/S3 angeschlossenen Speicherkondensator 70, der an den Bit-Treiber-Abfühlverstärker 74 angeschlossen ist, wird ein positiv gerichteter Spannungsimpuls Vw an die Wortleitung W/L, ein negativ gerichteter Impuls Vy2 an die Auswahlleitung Y2 vom Y-Treiber 76 angelegt, während die Bit-Abfühlleitung B/S3 auf einer konstanten Spannung von +Vb gehalten wird, so daß auf dem an B/S3 angeschlossenen Speicherkondensator 70 eine Ladung gespeichert wird. Zum Sperren der dem Transistorbereich 48 zugeordneten Speicherzellen wird Y1 auf Erdpotential gehalten, so daß der Basis-Kollektor-Übergang des Transistorbereichs 48 in Sperrichtung vorgespannt bleibt. Zum Einspeichern einer Null in den an der Bit-Abfühlleitung B/S3 angeschlossenen Speicherkondensator 70 wird das Potential der Bit-Abfühlleitung B/S3 auf 0 Volt abgesenkt, während die anderen Leitungen W/L, Y1 und Y2 die gleichen Spannungen wie vorher haben. Zum Auslesen von Information aus dem an der Bit-Abfühlleitung B/S3 angeschlossenen Speicherkondensator 70 wird der positiv gerichtete Spannungsimpuls Vw wiederum an die Wortleitung W/L und ein negativ gerichteter Impuls Vy2 an die Auswahlleitung Y2 angelegt, während die Spannung auf Y1 auf Erdpotential gehalten wird, wie dies in Fig. 12 gezeigt ist. Wenn ein Informationsbit Eins in dem Speicherkondensator 70 eingespeichert ist, dann steigt die Spannung auf der Bit-Abfühlleitung B/S3 an, und wenn in dem Speicherkondensator 70 ein Informationsbit Null gespeichert war, dann fällt die Spannung auf der Bit-Abfühlleitung B/S3 ab, wie dies in Fig. 12 bei B/S3 angedeutet ist. Die Spannungsdifferenz ΔV läßt sich zur Feststellung einer Eins oder einer Null, die im Speicherkondensator 70 abgespeichert ist, durch den Abfühlverstärker 74 leicht feststellen. Zum Einspeichern oder Lesen anderer Speicherkondensatoren des Transistorbereichs 50 werden die entsprechenden Bit-Abfühlleitungen B/S1, B/S2 oder B/S4 ausgewählt, während die gleichen Spannungen an die Leitungen W/L und Y2 angelegt werden.

Zum Einschreiben oder Auslesen der dem Transistorbereich 48 zugeordneten Speicherkondensatoren 70 werden gleichartige Spannungen und Leitungen ausgewählt, nur daß dann der Transistorbereich 50 dadurch gesperrt wird, daß die Auswahlleitung Y2 auf der Spannung 0 Volt gehalten wird, während an der Auswahlleitung Y1 eine negativ gerichtete Spannung Vy1 angelegt wird. Typische Steuerspannungsbereiche für Vw, Vy1, Vy2 und Vb sind −1,5 bis 0, −0,8 bis 0, −0,8 bis 0 bzw. 0 bis +1 Volt.

Obgleich zunächst nur eine erste und eine zweite Anzahl von Bits oder Worten durch isolierte Transistorbereiche 48 und 50 dargestellt worden waren, können weitere Bits oder Worte dadurch dargestellt werden, daß die Auswahlleitung Y1 an der Kollektorzone der einen Hälfte aller Bits oder Worte und die Auswahlleitung Y2 an der Kollektorzone der anderen Hälfte der Bits oder Worte angeschlossen werden.

Man sieht, daß sich durch die Erfindung ein sehr dichter Speicher herstellen läßt, der bei sehr hohen Geschwindigkeiten arbeitet.

Wie bereits in Verbindung mit dem Herstellungsverfahren der in Fig. 1—6 dargestellten Transistorstruktur erwähnt, können anstelle von aus Polysilicium bestehenden leitenden Schichten, die selbst passivierend oder selbst oxydierend sind, für diese Schichten andere selbst passivierende oder selbst oxydierende Materialien wie Aluminium, Tantal, Zirkon oder Niob und falls erwünscht auch Metall-Silicide verwendet werden. Außerdem kann die erste leitende Schicht auch mit anderen Störelementen als Bor dotiert werden, solange sie eine P-Leitfähigkeit bewirken, und die zweite leitende Schicht kann statt mit Arsen auch mit Phosphor oder jedem anderen Störelement, das eine N-Leitfähigkeit hervorruft, dotiert werden. Wenn natürlich anstelle des P-leitenden Halbleitersubstrats ein N-leitendes Halbleitersubstrat benutzt wird, dann müssen selbstverständlich alle Polaritäten umgekehrt werden.

Obgleich die Erfindung im Zusammenhang mit den Fign. 7—12 als Speicher dargestellt worden ist, so sollte doch ohne weiteres einleuchten, daß sich auf diese Weise auch logische Schaltungen, z.B. Strukturen mit integrierter Injektionslogik herstellen lassen können.

**Patentansprüche**

1. Verfahren zum Herstellen eines bipolaren Transistors mit einem Halbleitersubstrat (10; 46) eines ersten Leitungstyps mit einer einen Transistorbereich begrenzenden, eingelassenen Oxid-Isolationszone (12; 44), bei dem zunächst eine Kollektorzone (22, 27, 25; 58) und eine Basiszone (29; 56) im Halbleitersubstrat hergestellt werden, bei dem anschließend auf einem ersten Bereich der Oberfläche des Halbleitersubstrats eine erste leitende Schicht (30; 52) aus einem in einen isolierenden Zustand überführbaren Material aufgebracht wird, bei dem Störelemente des ersten Leitungstyps aus der ersten leitenden Schicht (30; 52) durch den ersten Bereich der Oberfläche des Halbleitersubstrats hindurch in die Basiszone (29, 56) eingeführt werden, bei dem auf der ersten leitenden Schicht (30; 52) eine erste Isolierschicht (32; 64) hergestellt und auf der ersten Isolierschicht und auf einem zweitem Bereich der Oberfläche des Halbleitersubstrats eine zweite leitende Schicht (34; 62) aufgebracht wird, dadurch gekennzeichnet, daß die einen zweiten Leitungstyp aufweisende Kollektorzone (22, 27, 25; 58) zur Bildung der Basiszone (29; 56) des ersten Leitungstyps teilweise mit Abstand von der Oberfläche des Halbleitersubstrats hergestellt wird, daß das Einführen der Störelemente aus der ersten leitenden Schicht (30; 52) zur Bildung eines Kontaktbereiches (31; 54) der Basiszone gilt, daß die erste Isolierschicht (32; 64) durch Überführung des an der außen liegenden Oberfläche angrenzenden Materials der ersten leitenden Schicht (30; 52) in einen isolierenden Zustand hergestellt wird, so daß die zweite leitende Schicht (34; 62) um die Dicke der ersten Isolierschicht (32; 64) mit Abstand von der verbleibenden ersten leitenden Schicht (30; 52) auf die Oberfläche des Halbleitersubstrats aufgebracht wird und daß Störelemente des zweiten Leitungstyps aus der zweiten leitenden Schicht (34; 62) durch den zweiten Bereich der Oberfläche des Halbleitersubstrats hindurch in die Basiszone zur Bildung einer Emitterzone (33; 60) eingeführt werden, die somit einen innerhalb der Dicke der ersten Isolierschicht (32; 64) liegenden Abstand von dem ersten Bereich aufweist.

2. Verfahren nach Anspruch 1, dadurch gekennzeichnet, daß die Kollektorzone (27, 25; 58) durch Ionen-Implantation in dem Transistorbereich mit zunehmender, von der Oberfläche des Substrats ausgehender oberer Grenze gebildet wird.

3. Verfahren nach Anspruch 2, dadurch gekennzeichnet, daß die Ionen über die gesamte Oberfläche des Transistorbereichs durch die auf der Oberfläche des Halbleitersubstrats niedergeschlagenen Schichten (14, 16, 25), die dem Durchdringen der Ionen einen unterschiedlichen Widerstand entgegensetzen, eingeführt werden.

4. Verfahren nach Anspruch 3, dadurch gekennzeichnet, daß die Ionen durch Schichten (14, 16, 25) aus verschiedenen Materialien hindurch implantiert werden.

5. Verfahren nach Anspruch 3, dadurch gekennzeichnet, daß eines der Materialien Photolack ist.

6. Verfahren nach Anspruch 1, dadurch gekennzeichnet, daß als erste leitende Schicht (30, 52) polykristallines Silicium, Aluminium, Tantal, Zirkon, Niob oder ein Metallsilicid verwendet wird.

7. Verfahren nach Anspruch 1, dadurch gekennzeichnet, daß als zweite leitende Schicht (34; 62) eine Schicht aus einem in den isolierenden Zustand überführbaren Material verwendet wird.

8. Verfahren nach Anspruch 7, dadurch gekennzeichnet, daß als zweite leitende Schicht (34; 62) eine Schicht aus polykristallinem Silicium verwendet wird.

9. Verfahren nach Anspruch 6, dadurch gekennzeichnet, daß die auf der ersten leitenden Schicht gebildete erste Isolierschicht (32; 64) durch Oxidation der Oberfläche der polykristallinen Siliciumschicht zu einer Polysilicium-Oxidschicht erzeugt wird.

10. Verfahren nach einem der Ansprüche 1 und 6 bis 9, dadurch gekennzeichnet, daß die erste leitende Schicht (30; 52) auf den ersten Bereich dadurch aufgebracht wird, daß innerhalb der Oxidations-Isolationszone auf der Oberfläche des Halbleitersubstrats eine isolierende Schicht (14, 16) aufgebracht wird, daß anschließend darauf eine Photolackschicht (26) aufgebracht wird, daß dann zur Festlegung des ersten Bereiches eine Öffnung (28) durch die Photolackschicht und die isolierende Schicht (14, 16) hindurch geätzt wird und daß dann die erste leitende Schicht (30) durch diese Öffnung (28) auf die Substratoberfläche aufgebracht wird.

11. Verfahren nach Anspruch 10, dadurch gekennzeichnet, daß daran anschließend die restlichen Teile der Photolackschicht (26) mit den darüberliegenden Teilen der ersten leitenden Schicht (30) entfernt werden und daß anschließend die erste Isolierschicht (32) gebildet wird.

12. Verfahren nach Anspruch 11, dadurch gekennzeichnet, daß danach der zur Herstellung der ersten leitenden Schicht (30) verbliebene Teil der isolierenden Schicht (14, 16) von der Oberfläche des Substrats entfernt wird und daß dann die zweite leitende Schicht (34) über der Isolierschicht (32) und über dem zweiten Bereich der Substratoberfläche angebracht wird.

13. Verfahren nach Anspruch 12, dadurch gekennzeichnet, daß über der zweiten leitenden Schicht (34) eine aus einem dielektrischen Material bestehende dritte Isolierschicht (36) und darüber eine dritte leitende Schicht angebracht wird.

14. Verfahren nach Anspruch 13, dadurch gekennzeichnet, daß elektrische Anschlüsse an die erste (30) und die dritte leitende Schicht und an einen die Kollektorzone kontaktierenden Teil der zweiten leitenden Schicht (35) hergestellt werden.

15. Verfahren nach einem oder mehreren der Ansprüche 1—14 zum gleichzeitigen Herstellen mehrerer Transistoren in einem einzigen Transistorbereich (48; 50) dadurch gekennzeichnet, daß die erste leitende Schicht (52) auf eine Anzahl ausgewählter, innerhalb des Transistorbereichs liegender erster Bereiche der Substratoberfläche aufgebracht wird, daß auf der ersten Isolierschicht und auf einer mit der Anzahl der ersten Bereiche gleich großen Anzahl von zweiten Bereichen der Substratoberfläche eine gleich große Anzahl von voneinander einen Abstand aufweisenden Einzelbereichen der zweiten leitenden Schicht (62) in der Weise angebracht werden, daß je einer der zweiten Bereiche je einem der ersten Bereiche unmittelbar benachbart ist.

16. Verfahren nach Anspruch 15, dadurch gekennzeichnet, daß als erste leitende Schicht ein anodisierbares Material verwendet wird und daß die ersten Bereiche der Substratoberfläche miteinander verbunden sind.

17. Verfahren nach den Ansprüchen 15 oder 16, dadurch gekennzeichnet, daß über jedem der Einzelbereiche der zweiten leitenden Schicht (62) eine dritte Isolierschicht aus dielektrischem Material aufgebracht wird und daß darüber eine gleich große Anzahl dritter leitender Schichten (68) zur Bildung einer gleich großen Anzahl von Kondensatoren aufgebracht wird.

**Revendications**

1. Procédé de fabrication d'un transistor bipolaire à substrat semi-conducteur (10, 46) d'un premier type de conductivité et à région d'isolation d'oxyde encastrée (12, 44) définissant une zone de transistor, par lequel on forme initialement une région de collecteur (22, 27, 25, 28) et une région de base (29, 56) dans ledit substrat semi-conducteur, on applique ensuite une première couche conductrice auto-passivante (30, 52) à une première partie de la surface dudit substrat semi-conducteur, on transfère des impuretés dudit premier type de conductivité de ladite première couche conductivité (30, 52) à ladite région de base (29, 56) au travers de ladite première partie de ladite surface dudit substrat semi-conducteur, on forme une première couche isolante (32, 64) sur ladite première couche conductrice (30, 52) et on applique une deuxième couche conductrice (34, 62) à ladite première couche isolante et à une deuxième partie de ladite surface dudit substrat semi-conducteur, caractérisé en ce que: ladite région de collecteur (22, 27, 25, 58) dudit deuxième type de conductivité est partiellement espacée de ladite surface dudit substrat semi-conducteur pour former ladite région de base (29, 56) dudit premier type de conductivité, lesdites impuretés sont transférées de ladite première couche conductrice (30, 52) pour former une région de contact (31, 54) dans ladite région de base, ladite première couche isolante (32, 64) est formée par auto-passivation du matériau de ladite première couche conductrice (30, 52) adjacente à la surface extérieure de façon que ladite deuxième couche conductrice (34, 62) soit appliquée à ladite surface dudit substrat semi-conducteur dans l'épaisseur de ladite première couche isolante (32, 64), et séparée du reste de ladite première couche conductrice (30, 52), et lesdites impuretés dudit deuxième type de conductivité sont transférées de ladite deuxième couche conductrice (34, 62) au travers de ladite deuxième partie de ladite surface dudit substrat semi-conducteur à ladite région de base pour former une région d'émetteur (33, 60) séparée, dans l'épaisseur de ladite première couche isolante (32, 64) de ladite première partie.

2. Procédé selon la revendication 1, caractérisé en ce que ladite région de collecteur (27, 25, 58) est formée par l'implantation d'ions dans la zone de transistor à des profondeurs croissantes commençant à partir de la surface dudit substrat.

3. Procédé selon la revendication 2, caractérisé en ce que les ions sont implantés sur toute la surface de ladite zone de transistor au travers des diverses couches (14, 16, 25) déposées sur ladite surface dudit substrat semi-conducteur offrant divers degrés de résistance à l'écoulement desdits ions.

4. Procédé selon la revendication 3, caractérisé en ce que lesdits ions sont implantés au travers des couches (14, 16, 25) de différents matériaux.

5. Procédé selon la revendication 3, caractérisé en ce que l'un desdits matériaux est photo-résistant.

6. Procédé selon la revendication 1, caractérisé en ce que du silicium polycristallin, de l'aluminium, du tantale, du zirconium, du niobium ou un siliciure metallique est utilisé en tant que première couche conductrice (30, 52).

7. Procédé selon la revendication 1, caractérisé en ce qu'une couche de matériau auto-passivant est utilisée en tant que deuxième couche conductrice (34, 62).

8. Procédé selon la revendication 7, caractérisé en ce qu'une couche de silicium polycristallin est utilisée en tant que deuxième couche conductrice (34, 62).

9. Procédé selon la revendication 6, caractérisé en ce que ladite première couche isolante (32, 64) sur ladite première couche conductrice est générée par l'oxydation de la surface de ladite couche de silicium polycristallin pour former une couche d'oxyde de polysilicium.

10. Procédé selon l'une des revendications 1, 6 à 9, caractérisé en ce que: ladite première couche conductrice (30, 52) est appliquée à ladite première partie par l'application d'une couche isolante (14, 16) à ladite surface dudit substrat semi-conducteur dans ladite région d'isolation par oxydation, une couche de matériau photo-résistant (26) est ensuite appliquée, une ouverture (28) est ménagée par décapage dans ladite couche de matériau photo-résistant et dans ladite couche isolante (14, 16) pour définir ladite première partie, et ladite première couche conductrice (30) est alors appliquée à la surface dudit substrat au travers de ladite ouverture (28).

11. Procédé selon la revendication 10, caractérisé en ce que: les parties restantes de ladite couche de matériau photo-résistant (26) ainsi que les parties de ladite première couche conductrice (30) appliquées sur celles-ci, sont ensuite retirées, et ladite première couche isolante (32) est alors formée.

12. Procédé selon la revendication 11, caractérisé en ce que: la partie restante de ladite couche isolante (14, 16) utilisée pour former ladite première couche conductrice (30) est retirée de la surface dudit substrat, et ladite deuxième couche conductrice (34) est appliquée sur ladite couche isolante (32) et sur ladite deuxième partie de la surface dudit substrat.

13. Procédé selon la revendication 12, caractérisé en ce qu'on applique une troisième couche isolante (36) de matériau diélectrique sur ladite deuxième couche conductrice (34), puis une troisième couche conductrice.

14. Procédé selon la revendication 13, caractérisé en ce que des contacts électriques sont disposées sur lesdites première (30) et troisième couches conductrices et sur une partie de ladite deuxième couche conductrice (35) en contact avec ladite région de collecteur.

15. Procédé selon l'une quelconque ou plusieurs des revendications 1 à 14 permettant la réalisation simultanée de plusieurs transistors dans une zone de transistor unique (48, 50), caractérisé en ce que: ladite première couche conductrice (52) est appliquée à plusieurs des premières parties sélectionées de la surface dudit substrat dans ladite zone de transistor, et un même nombre de segments espacés de ladite deuxième couche conductrice (2) sont appliqués à ladite première couche isolante et à un même nombre de deuxièmes parties sélectionnées de la surface dudit substrat de telle manière que chacune desdites deuxièmes parties soit immédiatement adjacente à l'une desdites premières parties.

16. Procédé selon la revendication 15, caractérisé en ce qu'un matériau anodisable est utilisé en tant que première couche conductrice et en ce que lesdites premières parties de la surface dudit substrat sont interconnectées.

17. Procédé selon la revendication 15 ou 16, caractérisé en ce qu'une troisième couche isolante de matériau diélectrique est appliquée sur chacun desdits segments de ladite deuxième couche conductrice (62) et en ce qu'un nombre égal de troisièmes couches conductrices est appliqué ensuite par dessus pour former un nombre égal de capacités.

**Claims**

1. Method of making a bipolar transistor with a semiconductor substrate (10; 46) of a first conductivity type with a recessed oxide isolation region (12; 44) defining a transistor area, wherein initially a collector region (22, 27, 25; 58) and a base region (29; 56) are formed in said semiconductor substrate, wherein subsequently a first self-passivating conductive layer (30; 52) is applied to a first portion of the surface of said semiconductor substrate, wherein impurities of said first conductivity type are passed from said first conductive layer (30; 52) to said base region (29, 56) through said first portion of said surface of said semiconductor substrate, wherein on said first conductive layer (30; 52) a first insulating layer (32; 64) is formed, and wherein a second conductive layer (34; 62) is applied to said first insulating layer and to a second portion of said surface of said semiconductor substrate, characterized in that said collector region (22, 27, 25; 58) of said second conductivity type is made so that part of it is spaced from said surface of said semiconductor substrate to form said base region (29; 56) of said first conductivity type, that said impurities are passed from said first conductive layer (30; 52) to form a contact region (31; 54) in said base region, that said first insulating layer (32; 64) is formed by self-passivation of the material of said first conductive layer (30; 52) adjacent to the outer surface, so that said second conductive layer (34; 62) is applied to said surface of said semiconductor substrate spaced within the thickness of said first insulating layer (32; 64) from the remainder of said first conductive layer (30; 52), and that said impurities of said second conductivity type are passed from said second conductive layer (34; 62) through said second portion of said surface of said semiconductor substrate to said base region to form an emitter region (33; 60) spaced within the thickness of said first insulating layer (32; 64) from said first portion.

2. Method in accordance with claim 1, characterized in that said collector region (27, 25; 58) is formed by implanting ions into the transistor area at increasing depths beginning from said substrate surface.

3. Method in accordance with claim 2, characterized in that the ions are implanted across the entire surface of said transistor area through the various layers (14, 16, 25) deposited on said surface of said semiconductor substrate providing various degrees of resistance to the flow of said ions.

4. Method in accordance with claim 3, characterized in that said ions are implanted through layers (14, 16, 25) of different materials.

5. Method in accordance with claim 3, characterized in that one of said materials is a photoresist.

6. Method in accordance with claim 1, characterized in that as a first conductive layer (30, 52) polycrystalline silicon, aluminium, tantalum, zirconium, niobium or a metallic silicide is used.

7. Method in accordance with claim 1, characterized in that as a second conductive layer (34; 62) a layer of a self-passivating material is used.

8. Method in accordance with claim 7, characterized in that as a second conductive layer (34; 62) a layer of polycrystalline silicon is used.

9. Method in accordance with claim 6, characterized in that said first isolating layer (32; 64) on said first conductive layer is generated by oxidizing the surface of said polycrystalline silicon layer to form a polysilicon oxide layer.

10. Method in accordance with any one of the claims 1 and 6 to 9, characterized in that said first conductive layer (30; 52) is applied to said first portion by applying an insulating layer (14, 16) to said surface of said semiconductor substrate within said oxidation isolation region, that subsequently a photoresist layer (26) is applied thereover, that for defining said first portion an opening (28) is etched through said insulating layer (14, 16), and that said first conductive layer (30) is then applied through said opening (28) to said substrate surface.

11. Method in accordance with claim 10, characterized in that subsequently the remaining portions of said photoresist layer (26) together with the portions of said first conductive layer (30) applied thereover are removed and that said first insulating layer (32) is then formed.

12. Method in accordance with claim 11, characterized in that the remaining portion of said insulating layer (14, 16) used to form said first conductive layer (30) is removed from said substrate surface and that said second conductive layer (34) is applied over said insulating layer (32) and over said second portion of said surface.

13. Method in accordance with claim 12, characterized in that over said second conductive layer (34) a third insulating layer (36) of dielectric material is applied which is followed by a third conductive layer.

14. Method in accordance with claim 13, characterized in that electrical contacts are provided to said first (30) and said third conductive layer and to a portion of said second conductive layer (35) contacting said collector region.

15. Method in accordance with any one or more of the claims 1—14 for simultaneously making several transistors in a single transistor area (48; 50), characterized in that said first conductive layer (52) is applied to a plurality of selected first portions of said substrate surface within said transistor area, that a like plurality of spaced segments of said second conductive layer (62) are applied to said first insulating layer and to a like plurality of selected second portions of said substrate surface in such a manner that each of said second portions is immediately adjacent to one of said first portions.

16. Method in accordance with claim 15, characterized in that as a first conductive layer an anodizable material is used and that said first portions of said substrate surface are interconnected.

17. Method in accordance with claim 15 or 16, characterized in that to each of said segments of said second conductive layer (62) a third insulating layer of dielectric material is applied and that thereover a like plurality of third conductive layers is applied to form a like plurality of capacitors.

FIG. 1

FIG. 2

FIG. 3

FIG. 4

FIG. 5

FIG. 6

**FIG. 7**

**FIG. 10**

**FIG. 8**

**FIG. 9**

FIG. 11

FIG. 12